# EUROPEAN PATENT APPLICATION

(11) **EP 4 773 452 A1**
(43) Date of publication of application: **08.07.2026**
(21) Application number: 24886023.1
(22) Date of filing: 13.09.2024
(51) Int. Cl.: H02H 3/20, H02M 1/32, H02M 1/08, G01R 19/165

(54) **POWER SUPPLY CIRCUIT AND ELECTRONIC DEVICE COMPRISING SAME**

(30) Priority: 31.10.2023 KR 20230148660; 19.12.2023 KR 20230186425
(71) Applicant: Samsung Electronics Co., Ltd., Suwon-si, Gyeonggi-do 16677 (KR)
(72) Inventor: LEE, Jongyoung, Suwon-si, Gyeonggi-do 16677 (KR); KIM, Soosan, Suwon-si, Gyeonggi-do 16677 (KR); YEON, Cheolo, Suwon-si, Gyeonggi-do 16677 (KR)
(74) Representative: Gulde & Partner
(86) International application number: PCT/KR2024/014064
(87) International publication number: WO 2025/095345

(57) **Abstract**

This power supply circuit may comprise: an input portion for obtaining power from a power supply; an output portion for providing power to an electronic component; a transistor arranged between the input portion and the output portion; a controller for providing an over-voltage (OV) protection function by selectively turning on or off a gate of the transistor, according to a comparison result of comparing a voltage of a control signal with a threshold value configured for the OV protection function; a resistor circuit arranged in parallel to the output portion; and a detection circuit connected to the resistor circuit to obtain at least a portion of a voltage applied to the output portion. The detection circuit may be configured to provide the controller with the control signal having a voltage greater than the threshold value when the voltage applied to the output portion is greater than a clamping voltage, and provide the controller with the control signal having a voltage less than or equal to the threshold value when the voltage applied to the output portion is less than or equal to the clamping voltage.

## Description

### [Technical Field]

The present disclosure relates to power supply circuitry and an electronic device including the power supply circuitry.

### [Background Art]

A voltage outside a normal operating range may be applied to an electronic device of a network system due to a transient state or malfunction. A power system for the electronic device may cut off power supply to the inside of the electronic device through a hot-swap controller having an over-voltage or under-voltage protection function.

The above-described information may be provided as a related art for a purpose of helping understanding of the present disclosure. No claim or determination is raised as to whether any of the above-described descriptions may be applied as a prior art related to the present disclosure.

### [Disclosure]

### [Technical Solution]

In embodiments, power supply circuitry is provided. The power supply circuitry may include an input portion for obtaining power from a power supply, an output portion for providing power to an electric component, a transistor disposed between the input portion and the output portion, a controller for providing an over-voltage (OV) protection function by turning-on or turning-off a gate of the transistor selectively according to a comparison result between a voltage of a control signal and a threshold configured for the OV protection function, resistor circuitry disposed in parallel to the output portion, and detection circuitry connected to the resistor circuitry to obtain at least a part of a voltage applied to the output portion. The detection circuitry may be configured to, in a case that the voltage applied to the output portion is higher than a clamping voltage, provide the control signal having a voltage higher than the threshold to the controller, and in a case that the voltage applied to the output portion is lower than or equal to the clamping voltage, provide the control signal having a voltage lower than or equal to the threshold to the controller. The clamping voltage may be lower than or equal to a tolerance voltage of the electric component.

In embodiments, an electronic device is provided. The electronic device may include a processor, and power supply circuitry configured to provide power to the processor. The power supply circuitry may include an input portion for obtaining power from a power supply, an output portion for providing power to an electric component, a transistor disposed between the input portion and the output portion, a controller for providing an over-voltage (OV) protection function by turning-on or turning-off a gate of the transistor selectively according to a comparison result between a voltage of a control signal and a threshold configured for the OV protection function, resistor circuitry disposed in parallel to the output portion, and detection circuitry connected to the resistor circuitry to obtain at least a part of a voltage applied to the output portion. The detection circuitry may be configured to, in a case that the voltage applied to the output portion is higher than a clamping voltage, provide the control signal having a voltage higher than the threshold to the controller, and in a case that the voltage applied to the output portion is lower than or equal to the clamping voltage, provide the control signal having a voltage lower than or equal to the threshold to the controller. The clamping voltage may be lower than or equal to a tolerance voltage of the electric component.

### [Description of the Drawings]

FIG. 1A illustrates a wireless communication system.
FIG. 1B illustrates an example of network entities of an electronic device.
FIG. 2 illustrates an example of power supply circuitry.
FIG. 3 illustrates components of detection circuitry.
FIGS. 4A and 4B illustrate an example of detection circuitry.
FIG. 5 illustrates another example of detection circuitry.
FIGS. 6A, 6B, and 6C illustrate examples of over-voltage control using detection circuitry.
FIG. 7 illustrates an example of components of an electronic device.

### [Mode for Invention]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

A term referring to a signal (e.g., a signal, information, a message, or signaling), a term for a calculation state (e.g., a step, an operation, or a procedure), a term referring to network entities, a term referring to a component of a device, a term referring to a part of an electronic device (e.g., a substrate, a printed circuit board (PCB), a flexible PCB (FPCB), a module, an antenna, an antenna element, circuitry, a processor, a chip, an integrated circuit (IC), a component, or a device), a term referring to circuitry (e.g., control circuitry, auxiliary circuitry, calculation circuitry, operation circuitry, RF circuitry, a PCB, an FPCB, a signal line, a feeding line, a data line, an RF signal line, an antenna line, an RF path, an RF module, a splitter, a divider, a coupler, or combiner), and the like, used in the following description, are exemplified for convenience of description. Therefore, the present disclosure is not limited to terms to be described below, and another term having an equivalent technical meaning may be used. In addition, a term such as '...unit', '...device', '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

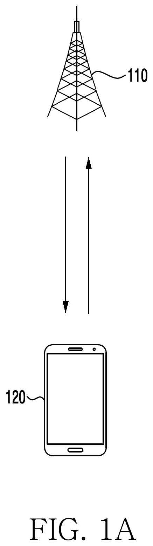

FIG. 1A illustrates a wireless communication system.

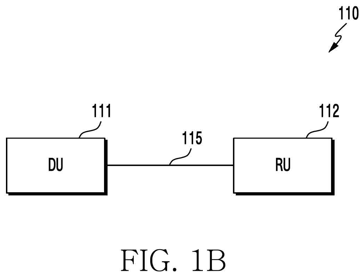

Referring to FIG. 1A, FIG. 1A exemplifies a base station 110 and a terminal 120 as a part of nodes using a wireless channel in the wireless communication system. Although FIG. 1 illustrates only one base station, the wireless communication system may further include another base station the same as or similar to the base station 110.

The base station 110 is a network infrastructure for providing wireless access to the terminal 120. The base station 110 has coverage defined based on a distance at which a signal may be transmitted. In addition to a base station, the base station 110 may be referred to as an 'access point (AP)', an 'eNodeB (eNB)', a '5th generation node (5G node)', a 'next generation nodeB (gNB)', a 'wireless point', a 'transmission/reception point (TRP)', or another term having an equivalent technical meaning thereto.

The terminal 120 is a device used by a user, and perform communication with the base station 110 through a wireless channel. A link from the base station 110 to the terminal 120 is referred to as a downlink (DL), and a link from the terminal 120 to the base station 110 is referred to as an uplink (UL). In addition, although not illustrated in FIG. 1, the terminal 120 and another terminal may perform communication with each other through a wireless channel. In this case, a link (a device-to-device link (D2D)) between the terminal 120 and the another terminal is referred to as a sidelink, and the sidelink may be used interchangeably with a PC5 interface. In some other embodiments, the terminal 120 may be operated without involvement of the user. According to an embodiment, the terminal 120 is a device that performs machine type communication (MTC), and may not be carried by the user. In addition, according to an embodiment, the terminal 120 may be a narrowband (NB)-internet of things (IoT) device. In addition to a terminal, the terminal 120 may be referred to as a 'user equipment (UE), a 'customer premises equipment (CPE)', a 'mobile station', a 'subscriber station', a 'remote terminal', a 'wireless terminal', an 'electronic device', a 'user device', or another term having an equivalent technical meaning thereto.

The base station 110 may transmit a signal to the terminal 120. The terminal 120 may receive a signal from the base station 110. The terminal 120 may transmit a signal to the base station 110. The base station 110 may receive a signal from the terminal 120. For example, the base station 110 and the terminal 120 may transmit and receive a wireless signal in a relatively low frequency band (e.g., frequency range 1 (FR 1) of NR). In addition, for example, the base station 110 and the terminal 120 may transmit and receive a wireless signal in a relatively high frequency band (e.g., FR 2 (or FR 2-1, FR 2-2, FR 2-3) or FR 3 of NR, or an mmWave band (e.g., 28 GHz, 30 GHz, 38 GHz, or 60 GHz)).

Conventionally, in a communication system with a relatively large cell radius of a base station, each base station was installed such that each base station includes a function of a digital processing unit (or a distributed unit (DU)) and a radio frequency (RF) processing unit (RF processing unit, or a radio unit (RU)). However, as a high frequency band is used in 4th generation (4G) and/or later communication systems (e.g., 5G), and cell coverage of the base station decreases, the number of base stations to cover a specific area has increased. A burden of an installation cost for an operator to install base stations has also increased. In order to minimize the installation cost of the base station, a structure has been proposed in which a DU and an RU of the base station are separated and one or more RUs are connected to one DU through a wired network, and one or more topologically distributed RUs are disposed to cover a specific area.

FIG. 1B illustrates an example of network entities of an electronic device. For example, the electronic device may include the base station 110 of FIG. 1A. The base station 110 may be separated into two or more entities through fronthaul. Unlike backhaul, the fronthaul refers to an interface between a DU and an RU between a wireless network and a core network. FIG. 1B illustrates an example of a fronthaul structure between a DU and one RU, but it is merely for convenience of description and the present disclosure is not limited thereto. In other words, an embodiment of the present disclosure may also be applied to a fronthaul structure between one DU and a plurality of RUs. For example, an embodiment of the present disclosure may be applied to a fronthaul structure between one DU and two RUs. In addition, an embodiment of the present disclosure may also be applied to a fronthaul structure between one DU and three RUs.

Referring to FIG. 1B, the base station 110 may include a DU 111 and an RU 112. A fronthaul 115 between the DU 111 and the RU 112 may be operated through an Fx interface. For the operation of the fronthaul 115, for example, an interface such as a common public radio interface (CPRI), an enhanced common public radio interface (eCPRI), and a radio over ethernet (ROE) may be used.

With development of communication technology, mobile data traffic has increased, and accordingly, a bandwidth requirement required in fronthaul between a digital unit and a wireless unit has increased significantly. In disposition such as a centralized/cloud radio access network (C-RAN), the DU 111 may be implemented to perform functions for packet data convergence protocol (PDCP), radio link control (RLC), media access control (MAC), and physical (PHY), and the RU 112 may be implemented to further perform functions for a PHY layer in addition to a radio frequency (RF) function.

The DU 111 may be responsible for an upper layer function of a wireless network. For example, the DU 111 may perform a function of MAC layer and a portion of a PHY layer. Herein, the portion of the PHY layer is performed at a higher level among functions of the PHY layer, and may include, as an example, channel encoding (or channel decoding), scrambling (or descrambling), modulation (or demodulation), layer mapping (or layer demapping). According to an embodiment, in a case that the DU 111 complies with an O-RAN standard, it may be referred to as an O-RAN DU (O-DU). The DU 111 may be represented by being replaced with a first network entity for a base station (e.g., a gNB) in embodiments of the present disclosure as needed.

The RU 112 may be responsible for a lower layer function of a wireless network. For example, the RU 112 may perform a portion of the PHY layer and an RF function. Herein, the portion of the PHY layer is performed at a relatively lower level than the DU 111 among functions of the PHY layer, and may include, as an example, iFFT conversion (or FFT conversion), CP insertion (CP removal), and digital beamforming. The RU 112 may be referred to as an 'access unit (AU)', an 'access point (AP)', a 'transmission/reception point (TRP)', a 'remote radio head (RRH)', a 'radio unit (RU)', or another term having an equivalent technical meaning thereto. According to an embodiment, in a case that the RU 112 complies with the O-RAN standard, it may be referred to as an O-RAN RU (O-RU). The RU 112 may be represented by being replaced with a second network entity for a base station (e.g., a gNB) in embodiments of the present disclosure as needed. According to an embodiment, digital predistortion (DPD) circuitry and processing circuitry for the DPD circuitry may be included in the RU 112 of the base station 110 having distributed disposition.

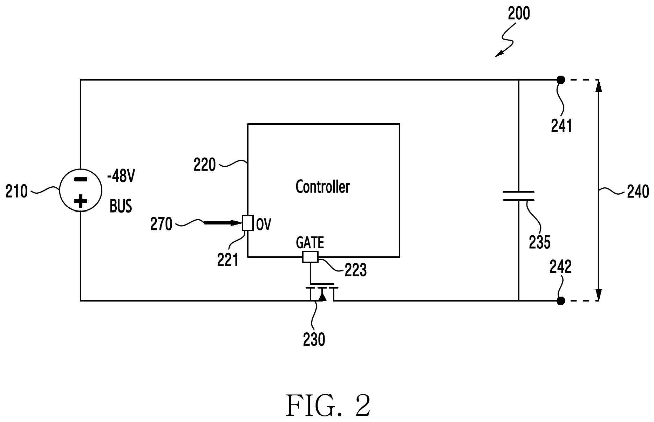

FIG. 2 illustrates an example of power supply circuitry. The power supply circuitry may be configured to supply a voltage to an electronic device (e.g., a base station 110, a DU 111, or an RU 112) configuring a communication system (e.g., a base station system).

Referring to FIG. 2, the power supply circuitry 200 may include a power source 210, a controller 220, a transistor 230, an input capacitor 235, and an output portion 240. The power supply circuitry 200 may supply a voltage to an electronic device (e.g., a base station 110, a DU 111, or an RU 112) connected to the output portion 240 through the power source 210. In FIG. 2, the power source 210 may refer to an input portion inputted to the power supply circuitry 200. The power supply circuitry 200 may obtain power from a power supply (e.g., a direct current (DC) bus power source) through the input portion. The electronic device may be connected between a first port 241 and a second port 242 of the output portion 240. For example, the power source 210 may provide negative power (e.g., a negative 48V direct current (DC) BUS) for a purpose of improving lifespan and protecting lightning strikes. The input capacitor 235 may be disposed in parallel between the first port 241 and the second port 242. The input capacitor 235 may be configured to stably supply power to an electronic device connected to the output portion 240 through charging and discharging. On the other hand, a normal operating range of the electronic device is generally at a level of approximately -38V to approximately -58V, but a voltage outside the normal operating range may be applied due to a transient state and malfunction.

The controller 220 may be used to set an operating range of the electronic device (e.g., the base station 110, the DU 111, or the RU 112). When a voltage outside the normal operating range (e.g., an over-voltage) is applied, the controller 220 may control the transistor 230 such that an over-voltage is not applied to the electronic device connected to the output portion 240. For example, the controller 220 may be a hot-swap controller. The hot-swap indicates a function that allows supply of the power source 210 to be safely cut off or re-applied in a state that the power supply circuitry 200 is connected to the electronic device. The controller 220 may protect the electronic device from malfunction by controlling an over-voltage (OV) or an under-voltage (UV) to the electronic device. According to an embodiment, the controller 220 may perform an over-voltage protection function. The controller 220 may include an over-voltage port 221 and a gate port 223. A control voltage 270 may be applied to the over-voltage port 221. The controller 220 may determine whether to perform the over-voltage protection function by comparing the control voltage 270 with an over-voltage threshold. For example, the controller 220 may include a comparator configured to compare the control voltage 270 and the over-voltage threshold according to a protection level. A signal outputted from the gate port 223 of the controller 220 may vary according to an output of the comparator. The transistor 230 may be a metal oxide semiconductor field effect transistor (MOSFET). The controller 220 may control on/off of a gate of the MOSFET through the gate port 223. The controller 220 may turn off a gate of the transistor 230 if the control voltage 270 higher than the over-voltage threshold is applied. Since a current does not flow through the transistor 230 as the gate of the transistor 230 is turned off, power supply to the output portion 240 may be cut off.

If an over-voltage transient or a continuous over-voltage occurs, since the over-voltage is applied to the inside of the electronic device as it is, a component (e.g., an MOSFET or a capacitor) with a higher internal voltage may be required in the electronic device. For example, by connecting a delay capacitor to an over-voltage port of a controller, the over-voltage protection function of the controller 220 may not operate for an over-voltage transient for a certain period of time (e.g., approximately several tens of milliseconds (ms)). Accordingly, the electronic device may maintain operation at the over-voltage transient. However, even if the delay capacitor is connected, since the over-voltage transient is applied to the inside of the electronic device as it is, a component having an enough internal voltage to withstand the over-voltage transient is required in the electronic device. For example, if a voltage exceeding an internal voltage is applied to the MOSFET even for a short time, a burnt failure may occur. A range of the applied voltage (e.g., a voltage supplied to the output portion 240) may have different required levels for each operator. For example, an over-voltage transient criterion included in a standard of a network equipment-building system (NEBS) may include maintaining a normal operation at a 75V level of applied voltage for approximately 10 ms time. The over-voltage transient criterion may be one in which a transient state and noise characteristics are reflected in addition to an operating range in a normal state. A maximum input voltage specification of the electronic device affects an internal voltage of a component inside the electronic device (e.g., a tolerance voltage for components in a power device (e.g., the power supply circuitry 200)). Meanwhile, as a component with a high internal voltage is applied, not only a size of a product increases, but also efficiency of the product may decrease. In the present disclosure, a circuitry structure for controlling clamping of an over-voltage transient in a negative power system is proposed to solve or alleviate the above-described problem.

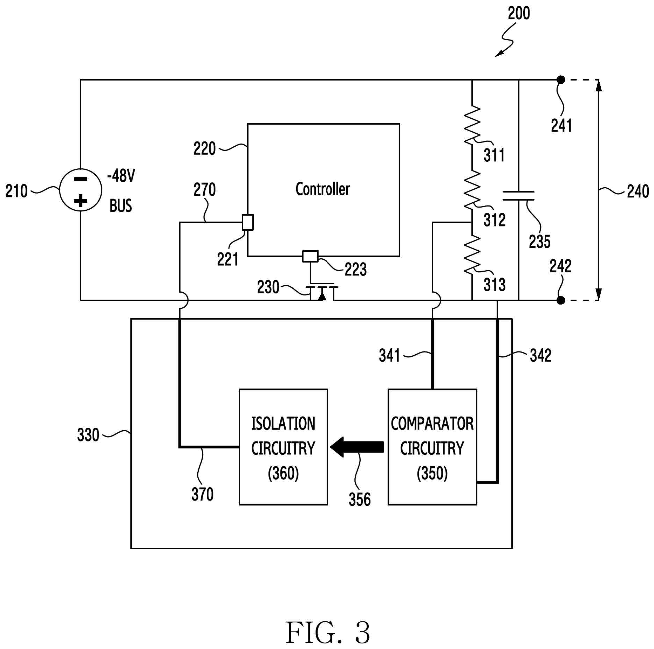

FIG. 3 illustrates components of detection circuitry.

Referring to FIG. 3, power supply circuitry 200 may include detection circuitry 330. The detection circuitry 330 is referred to as detection circuitry in terms of sensing whether a voltage applied to an output portion 240 exceeds a clamping voltage, but may be replaced with over-voltage protection control circuitry, clamping control circuity, clamping auxiliary circuitry, over-voltage protection circuitry, over-voltage control circuitry, over-voltage sensing circuitry, clamping sensing circuitry, control circuitry, auxiliary circuitry, sensing circuitry, or an equivalent technical term thereto.

The power supply circuitry 200 may include resistor circuitry. The resistor circuitry may include a plurality of resistors. The plurality of resistors may be used to measure a sensing voltage 341. In terms of measuring the sensing voltage 341, the plurality of resistors may be referred to as sensing resistors. The plurality of resistors may be arranged in series. The plurality of resistors may be disposed in parallel between a first node between a power source 210 and a first port 241 of the output portion 240 and a second node between a drain of a transistor 230 and a second port 242 of the output portion 240. The plurality of resistors may be disposed in parallel with an input capacitor 235. For example, the plurality of resistors may include a first resistor 311, a second resistor 312, and a third resistor 313. Although three resistors are illustrated in FIG. 3, embodiments of the present disclosure are not limited thereto. The three resistors are merely exemplary configurations for describing voltage distribution, and power supply circuitry including two or four or more resistors may also be understood as an embodiment of the present disclosure.

The detection circuitry 330 may include comparator circuitry 350 and isolation circuitry 360. The comparator circuitry 350 may be configured to compare the sensing voltage 341 and a reference voltage 342. The comparator circuitry 350 may obtain the sensing voltage 341. The sensing voltage 341 may correspond to a voltage applied between the second resistor 312 and the third resistor 313. The comparator circuitry 350 may obtain the reference voltage 342 from a voltage (e.g., a voltage of the second port 242) supplied to the output portion 240. The comparator circuitry 350 may output a signal 356 corresponding to a comparison result of the sensing voltage 341 and the reference voltage 342. The comparator circuitry 350 may transmit the signal 356 to the isolation circuitry 360. For example, in a case that the sensing voltage 341 is greater than the reference voltage 342, the comparator circuitry 350 may be configured to generate a first signal. In a case that the sensing voltage 341 is less than or equal to the reference voltage 342, the comparator circuitry 350 may be configured to generate a second signal. For example, a voltage range of the first signal may be higher than a voltage range of the second signal. The first signal may be a low-level signal or a low signal. The second signal may be a high-level signal or a high signal.

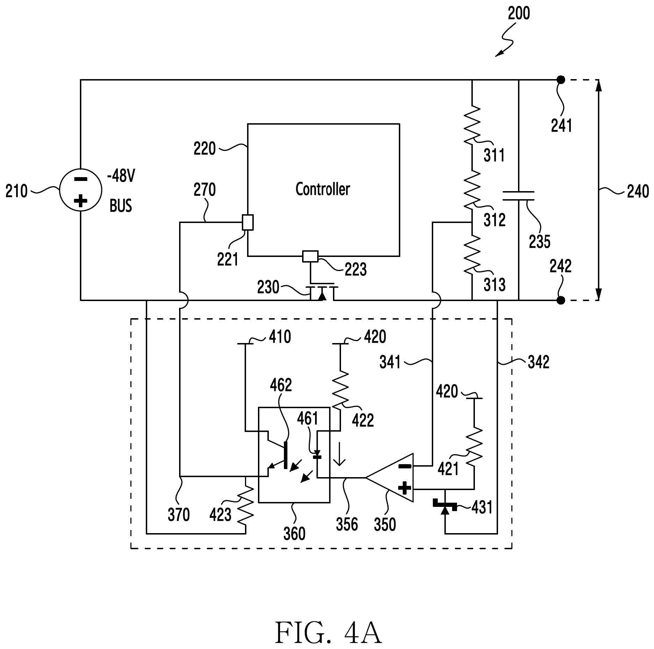

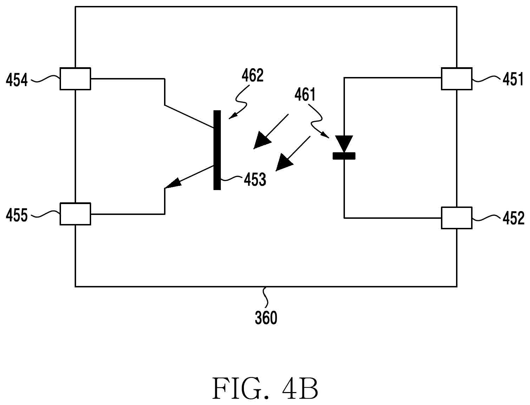

Comparing the sensing voltage 341 and the reference voltage 342 through the comparator circuitry 350 may correspond to comparing a voltage applied to the output portion 240 and a clamping voltage. The sensing voltage 341 may correspond to at least a part of the voltage applied to the output portion 240. The sensing voltage 341 may correspond to a designated ratio of the voltage applied to the output portion 240. For example, the sensing voltage 341 represents a voltage of a region among the resistors, disposed in series, of the resistor circuitry. The designated ratio may represent a ratio of at least one resistor value up to the region to a total resistor value of the resistors. The reference voltage 342 may correspond to a product of the clamping voltage and the designated ratio. A controller 220 may lower a voltage applied to the output end 240 to a certain voltage or less for over-voltage protection. The certain voltage represents a clamping voltage. According to an embodiment, the clamping voltage may be set lower than a tolerance voltage of an electronic component connected to the output end 240 (e.g., an internal voltage of a transistor). The reference voltage 342 may be determined according to the clamping voltage and the designated ratio according to the resistor circuitry. According to an embodiment, the power supply circuitry 200 may include a diode (e.g., a Zener diode, or a diode 431 of FIG. 4) that provides the reference voltage 342.

The isolation circuitry 360 may generate a control signal 370 in response to the signal 356 that is an output of the comparator circuitry 350. For example, in a case that the signal 356 is the first signal, the isolation circuitry 360 may be configured to generate the control signal 370 having a voltage greater than an over-voltage threshold. The first signal may indicate that the sensing voltage 341 is greater than the reference voltage 342. A current may flow inside the isolation circuitry 360 according to a magnitude of a voltage of the first signal. Accordingly, the control signal 370 of the isolation circuitry 360 may be generated. The control signal 370 may be provided to an over-voltage port 221 of the controller 220. A voltage of the control signal 370 may correspond to a control voltage 270. The voltage of the control signal 370 may be greater than an over-voltage threshold of the controller 220. In order to activate an over-voltage protection function of the controller 220, the isolation circuitry 360 may be configured to generate the control signal 370 having a voltage greater than the over-voltage threshold. For example, in a case that the signal 356 is the second signal, the isolation circuitry 360 may not generate the control signal 370 having a voltage greater than the over-voltage threshold.

The second signal may indicate that the sensing voltage 341 is less than or equal to the reference voltage 342. Since a current does not flow inside the isolation circuitry 360, an input part and an output part of the isolation circuitry 360 may be in a disconnected state with respect to each other. As a separate signal is not provided from the output part of the isolation circuitry 360, a control signal with a sufficient magnitude may not be generated. As an example of an implementation, a low-output signal may also be applied to the over-voltage port 221 according to a connection state of the circuitry. However, since a voltage of the signal is lower than the over-voltage threshold set in the controller 220, the over-voltage protection function of the controller 220 may not be activated.

Hereinafter, for convenience of description, the control signal 370 having a voltage greater than the over-voltage threshold may be referred to as a high signal or a high-level signal, and a signal having a voltage lower than the over-voltage threshold may be referred to as a low signal or a low-level signal. A voltage substantially close to '0' may be also understood as a signal having a voltage lower than the over-voltage threshold being applied.

FIGS. 4A and 4B illustrate an example of detection circuitry (e.g., detection circuitry 330). The same reference number may represent descriptions described for corresponding reference number in different drawings.

Referring to FIG. 4A, the detection circuitry 330 may include comparator circuitry 350 and isolation circuitry 360. The comparator circuitry 350 may include an operational (OP)-amplifier (AMP) (e.g., an OP-AMP IC). A negative pin of the comparator circuitry 350 may be electrically connected to an end between a second resistor 312 and a third resistor 313. A sensing voltage 341 may be inputted to the negative pin of the comparator circuitry 350. A positive pin of the comparator circuitry 350 may be electrically connected to a second port 242 of power supply circuitry 200 through a diode 431 (e.g., a Zener diode). A first power source 420 may be electrically connected to the positive pin of the comparator circuitry 350 through an input resistor 421. For example, the first power source 420 may be a supply power source V_{CC}. A reference voltage 342 may be inputted to the positive pin of the comparator circuitry 350. In a case that the sensing voltage 341 is greater than the reference voltage 342, the comparator circuitry 350 may be configured to generate a first signal. In a case that the sensing voltage 341 is less than or equal to the reference voltage 342, the comparator circuitry 350 may be configured to generate a second signal. For example, a voltage range of the first signal may be higher than a voltage range of the second signal. The first signal may be a low-level signal or a low signal. The second signal may be a high-level signal or a high signal. A signal 356 that is an output of the comparator circuitry 350 may be provided to the isolation circuitry 360.

The isolation circuitry 360 may include a photo-coupler. In order to describe a terminal of the photo-coupler, a structure exemplified in FIG. 4B may be referred to. FIG. 4B illustrates an example of isolation circuitry. Referring to FIG. 4B, the isolation circuitry 360 may include a light emitting element and a light receiving element as the photo-coupler. For example, the light emitting element may include a diode 461 (e.g., a light emitting diode). The light receiving element may include a bipolar junction transistor (BJT) 462. The diode 461 may correspond to an input part of the isolation circuitry 360. The diode 461 may include an anode 451 and a cathode 452. The anode 451 of the isolation circuitry 360 may be connected to the first power source 420 through a series resistor 422 (or that may be referred to as a diode resistor). The cathode 452 of the isolation circuitry 360 may be connected to an output of the comparator circuitry 350. In a case that the output of the comparator circuitry 350 is higher than a voltage applied to the anode 451, forward currents may flow from the anode 451 to the cathode 452 of the diode 461. In a case that the output of the comparator circuitry 350 is lower than or equal to a voltage applied to the anode 451, the forward currents may not flow.

Due to the forward currents of the diode 461, light may be transferred to the light receiving element. Due to the light, a current may flow to a base end 453 of the light receiving element. A collector 454 may be connected to a second power source 410. For example, the second power source 410 may be a drain supply voltage V_{DD}. An emitter 455 may be connected to a load resistor 423. The load resistor 423 may be connected between the emitter 455 and the power source 210. A current may flow from the collector 454 to the emitter 455 according to a current of the light receiving element. As the current is supplied to the load resistor 423, a control signal 370 may be generated. A voltage of the control signal 370 (e.g., a control voltage 270) may be applied to an over-voltage port 221 of a controller 220.

The detection circuitry 330 may be configured to transmit the control signal 370 to the over-voltage port 221 for an over-voltage protection function of the controller 220. If the control signal 370 is applied to the over-voltage port 221, an over-voltage transient of an output portion 240 of the power supply circuitry 200 may be clamped. In the output portion 240, the sensing voltage 341 according to a designated ratio (e.g., a ratio of a third resistor 313 to a first resistor 311 and a second resistor 312) may be inputted to the negative pin. If the over-voltage transient is applied, if it is higher than the reference voltage 342 of the positive pin, the comparator circuitry 350 may output a low signal. A voltage for triggering clamping (hereinafter, a clamping voltage) may be determined based on a ratio of sensing resistors (e.g., a ratio of the third resistor 313 to the first resistor 311 and the second resistor 312) and a magnitude of the reference voltage 342. For example, the clamping voltage may be determined by multiplying the reference voltage 342 by the ratio of the sensing resistors.

The control signal 370 may be applied to the over-voltage port 221 of the controller 220. In order to activate the over-voltage protection function of the controller 220, a voltage of the control signal 370 may be greater than an over-voltage threshold. A magnitude of the load resistor 423 may be determined such that the voltage of the control signal 370 is greater than the over-voltage threshold. A product of the magnitude of the load resistor 423 and collector currents may correspond to the voltage of the control signal 370. The collector currents may be a value obtained by multiplying a forward current I_{F} flowing through the diode 461 by a current transfer ratio (CTR). For example, a minimum value of a current flowing through the collector 454 may be a value obtained by multiplying forward currents by a minimum CTR. While a gate of a transistor 230 is turned off, the power source 210 and the output portion 240 may be electrically separated from each other. Accordingly, a voltage supplied to the output portion 240 may decrease. As the voltage supplied to the output portion 240 decreases, if a certain period of time elapses, the sensing voltage 341 may be lower than the reference voltage 342. As the detection circuitry 330 operates in reverse, the gate of the transistor 230 may be turned on again. While the gate is turned on, the voltage supplied to the output portion 240 may rise again. During a time when the over-voltage transient is applied, a voltage supplied to the output portion 240 may be clamped by repeating on and off of the gate. In a normal state in which an input voltage is maintained at a voltage lower than the clamping voltage, since the comparator circuitry 350 outputs the second signal, the isolation circuitry 360 may be in a state in which the input part (e.g., the diode 461) and an output part (e.g., the BJT 462) are disconnected. Since the forward currents do not flow through the diode 461, a current may not flow through the base end 453 of the BJT 462. Since the over-voltage protection function does not operate, the controller 220 may control the gate to continuously operate.

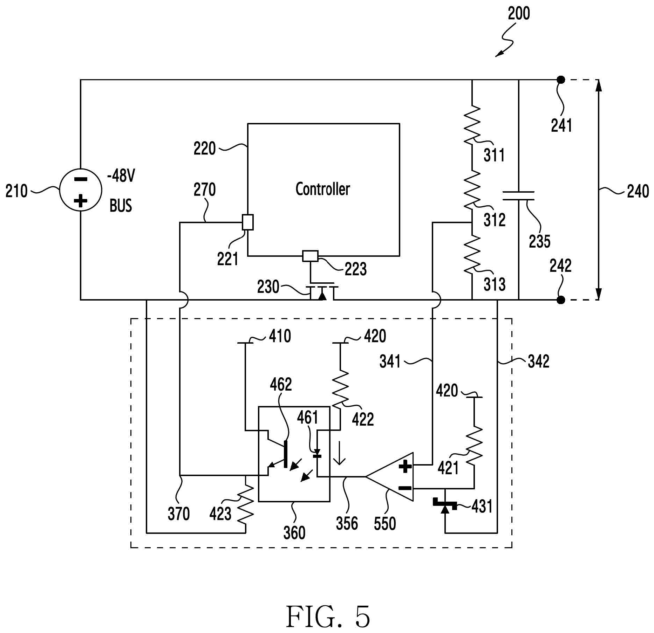

FIG. 5 illustrates another example of detection circuitry (e.g., detection circuitry 330). The detection circuitry 330 may include comparator circuitry 550 and isolation circuitry 360. The same reference number may represent descriptions described for corresponding reference number in different drawings.

Referring to FIG. 5, the detection circuitry 330 may include the comparator circuitry 550 and isolation circuitry 360. Referring to the circuitry structure of FIG. 4A, the comparator circuitry 550 may be used instead of the comparator circuitry 350. A sensing voltage 341 may be applied to a positive pin of the comparator circuitry 350. A reference voltage 342 may be applied to a negative pin of the comparator circuitry 350. For example, in a case that the sensing voltage 341 is greater than the reference voltage 342, the comparator circuitry 550 may be configured to generate a first signal. In a case that the sensing voltage 341 is less than or equal to the reference voltage 342, the comparator circuitry 550 may be configured to generate a second signal. For example, a voltage range of the first signal may be higher than a voltage range of the second signal. The first signal may be a low-level signal or a low signal. The second signal may be a high-level signal or a high signal. As the first signal has a signal in a low voltage range, forward currents may flow through a diode 461. In other words, only in a case that the sensing voltage 341 is greater than the reference voltage 342, the comparator circuitry 550 may generate a signal 356 such that forward currents flow through the diode 461.

The isolation circuitry 360 may include a photo-coupler. The isolation circuitry 360 may include a light emitting element and a light receiving element as the photo-coupler. For example, the light emitting element may include the diode 461 (e.g., a light emitting diode). The light receiving element may include a bipolar junction transistor (BJT) 462. In a case that an output of the comparator circuitry 550 is higher than a voltage applied to an anode 451, forward currents may flow from the anode 451 to a cathode 452 of the diode 461. In a case that an output of the comparator circuitry 550 is lower than or equal to a voltage applied to the anode 451, the forward currents may not flow. Due to the forward currents of the diode 461, light may be transferred to the light receiving element. Due to the light, a current may flow through a base end 453 of the light receiving element. A current may flow from a collector 454 to an emitter 455 according to the current of the light receiving element. As the current is supplied to a load resistor 423, a control signal 370 may be generated. A voltage of the control signal 370 (e.g., a control voltage 270) may be applied to an over-voltage port 221 of a controller 220.

Various types of circuitry may be configured using the principles illustrated in FIGS. 4A, 4B, and 5. In FIGS. 4A and 5, an example in which the output of the comparator circuitry is connected to the cathode 452 of the diode 461 of the isolation circuitry 360 has been described, but embodiments of the present disclosure are not limited thereto. For another example, the output of the comparator circuitry may also be connected to the anode 451 of the diode 461. In a case that the sensing voltage 341 is greater than the reference voltage 342, the comparator circuitry may be configured to output a high signal having a relatively high voltage. In a case that the sensing voltage 341 is less than or equal to the reference voltage 342, the comparator circuitry may be configured to output a low signal having a relatively low voltage. Only in a case that the sensing voltage 341 is greater than the reference voltage 342, the isolation circuitry 360 may be configured to output the control signal 370 having a voltage greater than an over-voltage threshold. In a case that the sensing voltage 341 is less than or equal to the reference voltage 342, the isolation circuitry 360 may be configured not to output the separate control signal 370 or to output a signal lower than the over-voltage threshold.

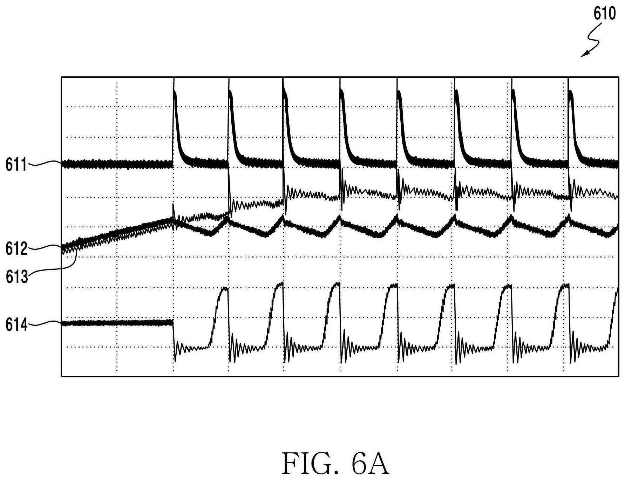

FIGS. 6A to 6C illustrate examples of over-voltage control using detection circuitry. In order to describe each waveform, the components of the power supply circuitry 200 exemplified in FIGS. 2, 3, 4A, 4B, and 5 may be referred to.

Referring to FIG. 6A, a graph 610 represents voltage waveforms. A first waveform 611 may represent a voltage at an over-voltage port 221 of a controller 220. A second waveform 612 may represent a voltage of a power source 210. A third waveform 613 may represent a voltage of an output portion 240. A fourth waveform 614 may represent a current at the power source 210. Even if an over-voltage transient is applied to the power source 210, detection circuitry 330 may be configured to clamp a voltage applied to the output portion 240 by repeatedly applying a high signal (e.g., a control signal 370 having a voltage greater than an over-voltage threshold of the controller 220) or a low signal (e.g., a signal having a voltage lower than the over-voltage threshold). Due to the clamping, a maximum voltage of the third waveform 613 may be smaller than a maximum voltage of the second waveform 612.

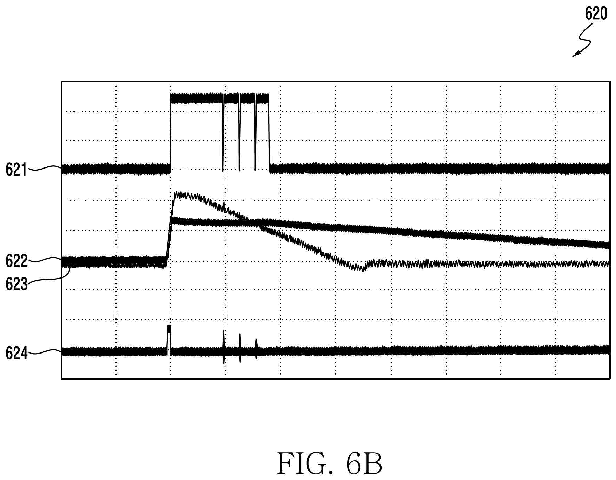

Referring to FIG. 6B, a graph 620 represents voltage waveforms when a load (e.g., an electronic device) is not connected to the output portion 240. A first waveform 621 may represent a voltage at the over-voltage port 221 of the controller 220. A second waveform 622 may represent a voltage of the power source 210. A third waveform 623 may represent a voltage of the output portion 240. A fourth waveform 624 may represent a current at the power source 210. The second waveform 622 may have a maximum over-voltage transient of 75V. The over-voltage transient having a magnitude of approximately 75V may be maintained for approximately 10 ms. The third waveform 623 may have a clamping voltage lower than or equal to a designated magnitude (e.g., 64V) due to the clamping due to the operation of the detection circuitry 330. As an example, the clamping voltage may be determined by multiplying a ratio of a reference voltage (e.g., a reference voltage 342) and sensing resistors (e.g., a first resistor 311, a second resistor 312, and a third resistor 313).

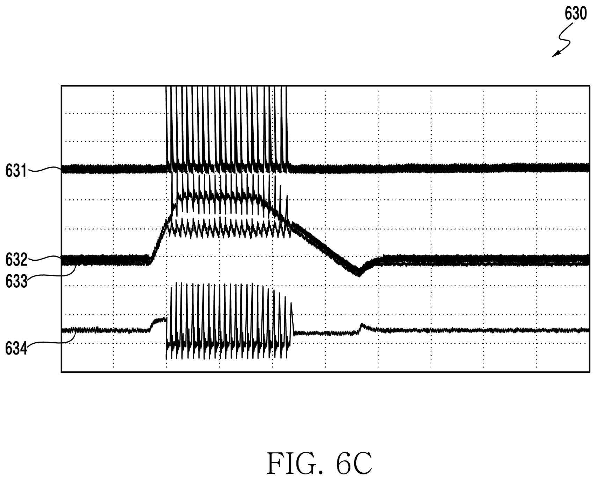

Referring to FIG. 6C, a graph 630 represents voltage waveforms when a load (e.g., an electronic device) is connected to the output portion 240. The graph 630 represents the voltage waveforms of the graph 610 more schematically. A first waveform 631 may represent a voltage at the over-voltage port 221 of the controller 220. A second waveform 632 may represent a voltage of the power source 210. A third waveform 633 may represent a voltage of the output portion 240. A fourth waveform 634 may represent a current in the power source 210. The second waveform 622 may have a maximum over-voltage transient of 75V. The over-voltage transient having a magnitude of approximately 75V may be maintained for approximately 10 ms. The third waveform 623 may have a clamping voltage lower than or equal to a designated magnitude (e.g., 64V) due to the clamping due to the operation of the detection circuitry 330. As an example, the clamping voltage may be determined by multiplying a ratio of a reference voltage (e.g., the reference voltage 342) and sensing resistors (e.g., the first resistor 311, the second resistor 312, and the third resistor 313). By clamping to a voltage lower than an internal voltage (or a tolerance voltage) defined in a product (e.g., an MOSFET), an over-voltage protection function may operate normally even if a voltage higher than the internal voltage is instantaneously applied.

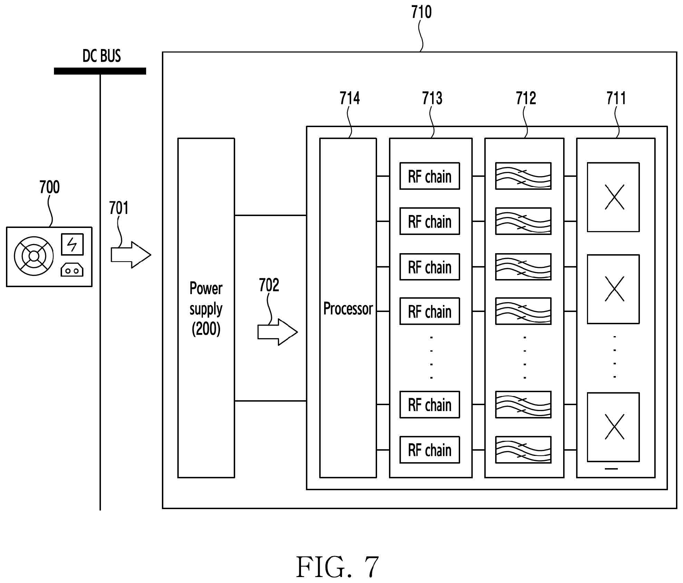

FIG. 7 illustrates an example of components of an electronic device.

Referring to FIG. 7, an exemplary functional configuration of an electronic device 710 is illustrated. For example, the electronic device 710 may be a base station 110 or an RU 112. As a non-limiting example, the electronic device 710 may also be a terminal 120. The electronic device 710 may include an antenna unit 711, a filter unit 712, a radio frequency (RF) processing unit 713, and a processor 714.

The power supply circuitry 200 described through FIGS. 2 to 6C may be provided a power source 701 (e.g., -48V) from a power supply source 700. The power source 701 may correspond to a power source 210 of the power supply circuitry 200. For example, the power source 701 may be provided to the electronic device 710 through a communication path shared by a plurality of components in a direct current (DC) bus method. The power supply circuitry 200 for the electronic device 710 may be configured to supply DC power 702 from the power source 701. For example, the power source 701 of approximately -48V may be converted into the DC power 702 of 12V. The DC power 702 may be applied to components (e.g., a DU 111, an RU 112, an MMU, a DU board, and an RU board) of the electronic device 710. In the power supply circuitry 200, the power source 701 of a negative power system may be used to supply the DC power 702 to a component (e.g., the processor 714 or a power amplifier of the RF processing unit 713) of the electronic device 710.

The antenna unit 711 may include a plurality of antennas. An antenna performs functions for transmitting and receiving a signal through a wireless channel. The antenna may include a radiator formed of a conductor or a conductive pattern formed on a substrate (e.g., a PCB). The antenna may radiate an up-converted signal on a wireless channel or obtain a signal radiated from another device. Each antenna may be referred to as an antenna element or an antenna device. According to an embodiment, the antenna unit 711 may include an antenna array in which a plurality of antenna elements form an array. The antenna unit 711 may be electrically connected to the filter unit 712 through RF signal lines. The antenna unit 711 may be mounted on a PCB including a plurality of antenna elements. The PCB may include a plurality of RF signal lines connecting each antenna element and a filter of the filter unit 712. These RF signal lines may be referred to as a feeding network. The antenna unit 711 may provide a received signal to the filter unit 712 or radiate a signal provided from the filter unit 712 into the air.

The filter unit 712 may perform filtering to transmit a signal of a desired frequency. The filter unit 712 may perform a function for selectively identifying a frequency by forming a resonance. The filter unit 712 may include at least one of a band pass filter, a low pass filter, a high pass filter, or a band reject filter. That is, the filter unit 712 may include RF circuits for obtaining a signal of a frequency band for transmission or a frequency band for reception. The filter unit 712 according to various embodiments may electrically connect the antenna unit 711 and the RF processing unit 713.

The RF processing unit 713 may include a plurality of RF processing circuits. According to an embodiment, the power supply circuitry 200 may be configured to supply the DC power 702 to components (e.g., a power amplifier and a low noise amplifier) of the RF processing unit 713. Each RF processing circuit is a unit of a path through which a signal received through an antenna or a signal radiated through the antenna passes, and may be referred to as an RF path. At least one RF path may be referred to as an RF chain. The RF chain may include a plurality of RF devices. The RF devices may include a power amplifier (PA), a mixer, an oscillator, a digital-to-analog converter (DAC), an analog-to-digital converter (ADC), and the like. For example, the RF processing unit 713 may include an up converter that up-converts a digital transmission signal of a base band into a transmission frequency and a DAC that converts the up-converted digital transmission signal into an analog RF transmission signal. The up converter and the DAC form a portion of a transmission path. The transmission path may further include a power amplifier or a coupler (or a combiner). In addition, for example, the RF processing unit 713 may include an ADC that converts an analog RF reception signal into a digital reception signal and a down converter that converts a digital reception signal into a digital reception signal of a base band. The ADC and the down converter form a portion of a reception path. The reception path may further include a low-noise amplifier (LNA) or a coupler (or a divider). RF components of an RF processing unit may be implemented on a PCB. For example, the electronic device 710 may include a structure stacked in an order of the antenna unit 711-the filter unit 712-the RF processing unit 713. For example, antennas and RF components of the RF processing unit may be implemented on a PCB. For example, filters may form a plurality of layers by being repeatedly fastened between a PCB and a PCB.

The RF processing unit 713 may include a plurality of RF processing chains for a plurality of signal paths transmitted to the antenna unit 711 and the filter unit 712. For example, the RF processing unit 713 may be an RFIC. The RFIC may include a plurality of RF processing chains. A signal applied in a baseband may be inputted to the RFIC. The signal inputted to the RFIC may be distributed to each antenna element. In this case, for beamforming, an independent phase transition may be applied to each of the antenna elements. Accordingly, the RFIC may include RF processing chains for processing a signal to be transmitted to each antenna element. Each RF processing chain may include one or more RF components for RF signal processing.

The processor 714 may control overall operations of the electronic device 710. According to an embodiment, the power supply circuitry 200 may be configured to supply the DC power 702 to the processor 714. The processor 714 may include various modules for performing communication. The processor 714 may include at least one processor such as a modem. The processor 714 may include modules for digital signal processing. For example, the processor 714 may include a modem. When transmitting data, the processor 714 generates complex symbols by encoding and modulating a transmission bit string. In addition, for example, when receiving data, the processor 714 restores a reception bit string through demodulating and decoding a baseband signal. The processor 714 may perform functions of a protocol stack required by a communication standard.

Methods for inputting power to network equipment include a negative input method and a positive input method. In a case of the positive input method, a diode (e.g., a clamping diode or a Zener diode) may be added to a gate port of a hot-swap controller. A voltage inputted to a system power source through the diode may be clamped. Even if a current is changed, the Zener diode may be configured such that a voltage remains constant. However, in a case of a negative input system, since potentials of a source of a transistor (e.g., an MOSFET) and an input end of a system power source of an electronic component are different, it may be difficult to simply clamp a voltage of the input end through a diode. The detection circuitry according to embodiments of the present disclosure may be configured to clamp a voltage applied to the output portion 240, by adaptively applying the control signal 370 to the over-voltage port 221 of the controller 220 through the operation of the comparator circuitry 350 (or the comparator circuitry 550) and the isolation circuitry 360.

The power supply circuitry 200 according to embodiments of the present disclosure may clamp a voltage applied to the output portion 240 through the detection circuitry 330. In general, when selecting a component, a component with a high internal voltage to withstand an over-voltage transient should be applied, but through clamping of the present disclosure, a component with a relatively low internal voltage may be used. For example, approximately 16 components of 150 micro farad (uF) with an internal voltage of approximately 80V should be applied in a circuitry structure to which an over-voltage transient is applied as before. However, if a structure of the power supply circuitry 200 according to embodiments of the present disclosure is applied, components of 240 uF with an internal voltage of approximately 63V may be applied. In a circuitry design that requires a capacitance of approximately 2400 uF, the number of required capacitors may decrease from 16 to 10. As the number of capacitors decreases, a size of the electronic device (e.g., the base station 110, the DU 111, or the RU 112) may decrease. Since an over-voltage transient is clamped and applied to a product, an operation of the electronic device may be maintained while an effect due to the over-voltage transient is reduced. Since a component with a low internal voltage may be applied, it is possible to reduce a product size and reduce a cost. For example, by reducing a capacitor inside the circuitry, miniaturization may be achieved, and communication performance may be improved due to characteristics of network equipment in which a plurality of RF components are mounted.

The effects that may be obtained from the present disclosure are not limited to those described above, and any other effects not mentioned herein will be clearly understood by those having ordinary knowledge in the art to which the present disclosure belongs, from the following description.

In embodiments, network power supply circuitry 200 is provided. The network power supply circuitry 200 may include a power source 210, a transistor 230 disposed between the power source 210 and an input end 240, a controller 220 for controlling a gate of the transistor 230, resistance circuitry disposed in parallel to the input end, and clamping control circuitry 330. The detection circuitry 330 may include comparator circuitry 350 configured to output a first signal or a second signal according to a comparison result between a sensing voltage 341 and a reference voltage 342 obtained through the resistor circuitry, and isolation circuitry 360 configured to provide a control signal to an over-voltage (OV) port of the controller 220 in response to the first signal that is an output of the comparator circuitry 350. The controller 220 may be configured to turn off the gate of the transistor 230 according to the control signal applied to the over-voltage port 221.

According to an embodiment, in a case that the sensing voltage 341 is greater than the reference voltage 342, the comparator circuitry 350 may be configured to output the first signal. In a case that the sensing voltage 341 is less than or equal to the reference voltage 342, the comparator circuitry 350 may be configured to output the second signal. A voltage range of the first signal may be lower than a voltage range of the second signal.

According to an embodiment, the isolation circuitry 360 may be configured to generate the control signal through a diode 461 of the isolation circuitry 360 in response to the first signal and supply the control signal to the over-voltage port 221 of the controller 220. A voltage of the control signal may be higher than an over-voltage threshold set in the controller 220 for over-voltage protection.

According to an embodiment, the detection circuitry 330 may further include a load resistor disposed between the over-voltage port 221 of the controller 220 and the power source 210. A voltage of the control signal may be determined based on a magnitude of the load resistor.

According to an embodiment, the isolation circuitry 360 may include the diode 461 and a bipolar junction transistor (BJT) 462. Forward currents from an anode of the diode 461 to a cathode of the diode 461 may cause collector currents to flow from a collector of the BJT 462 to an emitter of the BJT 462. A product of the magnitude of the load resistor and the collector currents may be greater than the over-voltage threshold of the controller 220.

According to an embodiment, an output end of the comparator circuitry 350 may be electrically connected to the cathode of the diode 461.

According to an embodiment, the detection circuitry 330 may further include a resistor of the diode 461 connected between the anode of the diode 461 and a first power source. The forward currents may be determined based on the resistor of the diode 461 and the first power source.

According to an embodiment, the collector of the BJT 462 may be connected to a second power source. The emitter of the BJT 462 may be connected to the load resistor and the over-voltage port 221 of the controller 220, respectively.

According to an embodiment, the isolation circuitry 360 may include the diode 461 disposed such that a current does not pass through in response to the second signal that is an output of the comparator circuitry 350.

According to an embodiment, in a case that a voltage of a signal applied to the over-voltage port 221 is higher than an over-voltage threshold set in the controller 220, the controller 220 may be configured to turn off the gate. In a case that a voltage of a signal applied to the over-voltage port 221 is lower than or equal to the over-voltage threshold set in the controller 220, the controller 220 may be configured to turn on the gate. According to an embodiment, the resistor circuitry may include resistors arranged in series. The resistors may be disposed in parallel between a first node between the power source 210 and a first port of the input end 240 and a second node between a drain of the transistor 230 and a second port of the input end. The sensing voltage 341 may be obtained from at least one of the resistors and supplied to a negative port of the comparator circuitry 350. The reference voltage 342 may be supplied to a positive port of the comparator circuitry 350.

According to an embodiment, the power source 210 may be provided through a negative 48 voltage (V) direct current (DC) bus system. The controller 220 may include a hot-swap controller. According to an embodiment, the network power supply circuitry 200 may further include an input capacitor connected in parallel to the input end. The over-voltage port 221 of the controller 220 may be connected to the isolation circuitry 360 without a capacitor.

In embodiments, an electronic device is provided. The electronic device may include a processor, a plurality of radio frequency (RF) processing circuits, a plurality of antennas, and power supply circuits 200 configured to provide power to at least one of the processor or the plurality of RF processing circuits. Among the power supply circuits 200, each power supply circuit 200 may include a power source, a transistor 230 disposed between the power source 210 and an input end 240, a controller 220 for controlling a gate of the transistor 230, resistor circuitry disposed in parallel to the input end, and clamping control circuitry 330. The detection circuitry 330 may include comparator circuitry 350 configured to output a first signal or a second signal according to a comparison result between a sensing voltage 341 and a reference voltage 342 obtained through the resistor circuitry, and isolation circuitry 360 configured to provide a control signal to an over-voltage (OV) port of the controller 220 in response to the first signal that is an output of the comparator circuitry 350. The controller 220 may be configured to turn off the gate of the transistor 230 according to the control signal applied to the over-voltage port 221.

According to an embodiment, in a case that the sensing voltage 341 is greater than the reference voltage 342, the comparator circuitry 350 may be configured to output the first signal. In a case that the sensing voltage 341 is less than or equal to the reference voltage 342, the comparator circuitry 350 may be configured to output the second signal. A voltage range of the first signal may be lower than a voltage range of the second signal.

According to an embodiment, the isolation circuitry 360 may be configured to generate a control signal through a diode 461 of the isolation circuitry 360 in response to the first signal and supply the control signal to the over-voltage port 221. A voltage of the control signal may be higher than an over-voltage threshold set in the controller 220 for over-voltage protection.

According to an embodiment, the controller 220 may be configured to turn off the gate in a case that a signal applied to the over-voltage port 221 is higher than an over-voltage threshold set in the controller 220 and turn on the gate in a case that a signal applied to the over-voltage port 221 is lower than or equal to the over-voltage threshold set in the controller 220.

According to an embodiment, the isolation circuitry 360 of each of the power supply circuits 200 may include the diode 461 disposed such that a current does not pass through in response to the second signal that is an output of the comparator circuitry 350.

According to an embodiment, a capacitor may not be connected to the over-voltage port 221 of the controller 220 of each of the power supply circuits 200.

According to an embodiment, the power source 210 may be provided through a negative 48 voltage (V) direct current (DC) bus system. The controller 220 may include a hot-swap controller. The power supply circuits 200 may be used to supply DC power to power amplifiers among the plurality of RF processing circuits.

In embodiments, power supply circuitry is provided. The power supply circuitry may include an input portion for obtaining power from a power supply, an output portion for providing power to an electric component, a transistor disposed between the input portion and the output portion, a controller for providing an over-voltage (OV) protection function by turning-on or turning-off a gate of the transistor selectively according to a comparison result between a voltage of a control signal and a threshold configured for the OV protection function, resistor circuitry disposed in parallel to the output portion, and detection circuitry connected to the resistor circuitry to obtain at least a part of a voltage applied to the output portion. The detection circuitry may provide, in a case that the voltage applied to the output portion is higher than a clamping voltage, the control signal having a voltage higher than the threshold to the controller. The detection circuitry may be configured to provide, in a case that the voltage applied to the output portion is lower than or equal to the clamping voltage, the control signal having a voltage lower than or equal to the threshold to the controller. The clamping voltage may be lower than or equal to a tolerance voltage of the electric component.

According to an embodiment, the detection circuitry may include comparator circuitry configured to obtain a sensing voltage corresponding to a designated ratio of the voltage applied to the output portion through the resistor circuitry, output a first signal in a case that the sensing voltage is higher than a reference voltage, and output a second signal in a case that the sensing voltage is lower than or equal to the reference voltage.

According to an embodiment, the detection circuitry may include isolation circuitry configured to, in response to the first signal, generate the control signal having the voltage higher than the threshold, in response to the second signal, generate the control signal having the voltage lower than or equal to the threshold, and provide the control signal to an OV port of the controller.

According to an embodiment, the isolation circuitry may include a load resistor disposed between the input portion and the OV port of the controller. The voltage of the control signal may be determined based on a magnitude of the load resistor.

According to an embodiment, the isolation circuitry may include a diode and a bipolar junction transistor (BJT). Forward currents from an anode of the diode to a cathode of the diode may cause collector currents to flow from a collector of the BJT to an emitter of the BJT. A magnitude of the collector currents with the magnitude of the load resistor may provide the control signal having the voltage higher than the threshold.

According to an embodiment, the cathode of the diode may be electrically connected to an output end of the comparator circuitry. The anode of the diode may be electrically connected to a first power source providing a collector voltage. A magnitude of the forward currents may be determined based on a difference between the collector voltage and a voltage of the first signal from the comparator circuitry.

According to an embodiment, the collector of the BJT may be connected to a second power source providing a device voltage. The emitter of the BJT may be connected to each of the load resistor and the OV port of the controller.

According to an embodiment, the resistor circuitry may include resistors arranged in series. The resistors may be disposed in parallel between a first node between the power source and a first port of the output portion, and a second node between a drain of the transistor and a second port of the output portion.

According to an embodiment, the power may be provided through a negative 48 voltage (V) direct current (DC) bus system. The controller may include a hot-swap controller.

According to an embodiment, the power supply circuitry may further include an input capacitor connected to the output portion in parallel. The OV port of the controller may be connected to the input portion without a capacitor.

In embodiments, an electronic device is provided. The electronic device may include a processor, and power supply circuitry configured to provide power to the processor. The power supply circuitry may include an input portion for obtaining power from a power supply, an output portion for providing power to an electric component, a transistor disposed between the input portion and the output portion, a controller for providing an over-voltage (OV) protection function by turning-on or turning-off a gate of the transistor selectively according to a comparison result between a voltage of a control signal and a threshold configured for the OV protection function, resistor circuitry disposed in parallel to the output portion, and detection circuitry connected to the resistor circuitry to obtain at least a part of a voltage applied to the output portion. The detection circuitry may provide, in a case that the voltage applied to the output portion is higher than a clamping voltage, the control signal having a voltage higher than the threshold to the controller. The detection circuitry may be configured to, in a case that the voltage applied to the output portion is lower than or equal to the clamping voltage, provide the control signal having a voltage lower than or equal to the threshold to the controller. The clamping voltage may be lower than or equal to a tolerance voltage of the electric component.

According to an embodiment, the detection circuitry may include comparator circuitry configured to obtain a sensing voltage corresponding to a designated ratio of the voltage applied to the output portion through the resistor circuitry, output a first signal in a case that the sensing voltage is higher than a reference voltage, and output a second signal in a case that the sensing voltage is lower than or equal to the reference voltage.

According to an embodiment, the detection circuitry may include isolation circuitry configured to, in response to the first signal, generate the control signal having the voltage higher than the threshold, in response to the second signal, generate the control signal having the voltage lower than or equal to the threshold, and provide the control signal to an OV port of the controller.

According to an embodiment, the isolation circuitry may include a load resistor disposed between the input portion and the OV port of the controller. The voltage of the control signal may be determined based on a magnitude of the load resistor.

According to an embodiment, the isolation circuitry may include a diode and a bipolar junction transistor (BJT). Forward currents from an anode of the diode to a cathode of the diode may cause collector currents to flow from a collector of the BJT to an emitter of the BJT. A magnitude of the collector currents with the magnitude of the load resistor may provide the control signal having the voltage higher than the threshold.

According to an embodiment, the cathode of the diode may be electrically connected to an output end of the comparator circuitry. The anode of the diode may be electrically connected to a first power source providing a collector voltage. A magnitude of the forward currents may be determined based on a difference between the collector voltage and a voltage of the first signal from the comparator circuitry.

According to an embodiment, the collector of the BJT may be connected to a second power source providing a device voltage. The emitter of the BJT may be connected to each of the load resistor and the OV port of the controller.

According to an embodiment, the resistor circuitry may include resistors arranged in series. The resistors may be disposed in parallel between a first node between the power source and a first port of the output portion, and a second node between a drain of the transistor and a second port of the output portion.

According to an embodiment, the power may be provided through a negative 48 voltage (V) direct current (DC) bus system. The controller may include a hot-swap controller.

According to an embodiment, the power supply circuitry may include an input capacitor connected to the output portion in parallel. The OV port of the controller may be connected to the input portion without a capacitor.

For one or more embodiments, at least one of the components described in one or more of the preceding drawings may be configured to perform one or more operations, techniques, processes and/or methods as described in the present disclosure. For example, the processor (e.g., a baseband processor) described in the present disclosure in relation to one or more of the preceding drawings may be configured to operate according to one or more examples described in the present disclosure. For another example, circuitry associated with user equipment (UE), a base station, a network element, and the like, as described above related to one or more of the previous drawings, may be configured to operate according to one or more examples described herein.

Arbitrary one of the embodiments described above may be combined with arbitrary other embodiment (or a combination of embodiments) unless otherwise explicitly stated. The above-described description of one or more implementations provides examples and descriptions, but is not intended to limit or to be exhaustive of a scope of an embodiment in a precise form disclosed. In light of the above teachings, modifications and variations may be possible or may be obtained from practice of various embodiments.

Methods according to embodiments described in claims or specifications of the present disclosure may be implemented as a form of hardware, software, or a combination of hardware and software.

In a case of implementing as software, a computer-readable storage medium for storing one or more programs (software module) may be provided. The one or more programs stored in the computer-readable storage medium are configured for execution by one or more processors in an electronic device. The one or more programs include instructions that cause the electronic device to execute the methods according to embodiments described in claims or specifications of the present disclosure. The one or more programs may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. In the case of being distributed online, at least part of the computer program product may be temporarily generated or at least temporarily stored in the machine-readable storage medium, such as memory of the manufacturer's server, the application store's server, or a relay server.

Such a program (software module, software) may be stored in a random access memory, a non-volatile memory including a flash memory, a read only memory (ROM), an electrically erasable programmable read only memory (EEPROM), a magnetic disc storage device, an optical storage device (e.g., a compact disc-ROM (CD-ROM), digital versatile discs (DVDs), or other formats), or a magnetic cassette. Alternatively, it may be stored in memory configured with a combination of some or all of them. In addition, a plurality of configuration memories may be included.

Additionally, a program may be stored in an attachable storage device that may be accessed through a communication network such as the Internet, Intranet, local area network (LAN), wide area network (WAN), or storage area network (SAN), or a combination thereof. Such a storage device may be connected to a device performing an embodiment of the present disclosure through an external port. In addition, a separate storage device on the communication network may also be connected to a device performing an embodiment of the present disclosure.

In the above-described specific embodiments of the present disclosure, components included in the disclosure are expressed in the singular or plural according to the presented specific embodiment. However, the singular or plural expression is selected appropriately according to a situation presented for convenience of explanation, and the present disclosure is not limited to the singular or plural component, and even components expressed in the plural may be configured in the singular, or a component expressed in the singular may be configured in the plural.

According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be executed sequentially, in parallel, repeatedly, or heuristically, or one or more of the operations may be executed in a different order or omitted, or one or more other operations may be added.

Meanwhile, specific embodiments have been described in the detailed description of the present disclosure, and of course, various modifications are possible without departing from the scope of the present disclosure.

## Claims

1. Power supply circuitry, comprising:
an input portion for obtaining power from a power supply;
an output portion for providing power to an electric component;
a transistor disposed between the input portion and the output portion;
a controller for providing an over-voltage (OV) protection function by turning-on or turning-off a gate of the transistor selectively according to a comparison result between a voltage of a control signal and a threshold configured for the OV protection function;
resistor circuitry disposed in parallel to the output portion; and
detection circuitry connected to the resistor circuitry to obtain at least a part of a voltage applied to the output portion,
wherein the detection circuitry is configured to:
in a case that the voltage applied to the output portion is higher than a clamping voltage, provide the control signal having a voltage higher than the threshold to the controller, and
in a case that the voltage applied to the output portion is lower than or equal to the clamping voltage, provide the control signal having a voltage lower than or equal to the threshold to the controller, and
wherein the clamping voltage is lower than or equal to a tolerance voltage of the electric component.

2. The power supply circuitry of the claim 1, wherein the detection circuitry includes:
comparator circuitry configured to:
obtain a sensing voltage corresponding to a designated ratio of the voltage applied to the output portion through the resistor circuitry,
output a first signal in a case that the sensing voltage is higher than a reference voltage, and
output a second signal in a case that the sensing voltage is lower than or equal to the reference voltage.

3. The power supply circuitry of the claim 2, wherein the detection circuitry includes:
isolation circuitry configured to:
in response to the first signal, generate the control signal having the voltage higher than the threshold,
in response to the second signal, generate the control signal having the voltage lower than or equal to the threshold, and
provide the control signal to an OV port of the controller.

4. The power supply circuitry of the claim 3,
wherein the isolation circuitry includes a load resistor disposed between the input portion and the OV port of the controller, and
wherein the voltage of the control signal is determined based on a magnitude of the load resistor.

5. The power supply circuitry of the claim 4,
wherein the isolation circuitry includes a diode and a bipolar junction transistor (BJT),
wherein forward currents from an anode of the diode to a cathode of the diode cause collector currents to flow from a collector of the BJT to an emitter of the BJT, and
wherein a magnitude of the collector currents with the magnitude of the load resistor provides the control signal having the voltage higher than the threshold.

6. The power supply circuitry of the claim 5,
wherein the cathode of the diode is electrically connected to an output end of the comparator circuitry,
wherein the anode of the diode is electrically connected to a first power source providing a collector voltage, and
wherein a magnitude of the forward currents is determined based on a difference between the collector voltage and a voltage of the first signal from the comparator circuitry.

7. The power supply circuitry of the claim 6,
wherein the collector of the BJT is connected to a second power source providing a device voltage, and
wherein the emitter of the BJT is connected to each of the load resistor and the OV port of the controller.

8. The power supply circuitry of the claim 1,
wherein the resistor circuitry includes resistors arranged in series, and
wherein the resistors are disposed in parallel between:
a first node between the power source and a first port of the output portion, and
a second node between a drain of the transistor and a second port of the output portion.

9. The power supply circuitry of the claim 1,
wherein the power is provided through a negative 48 voltage (V) direct current (DC) bus system, and
wherein the controller includes a hot-swap controller.

10. The power supply circuitry of the claim 1, further comprising:
an input capacitor connected to the output portion in parallel,
wherein the OV port of the controller is connected to the input portion without a capacitor.

11. An electronic device, comprising
a processor; and
power supply circuitry configured to provide power to the processor,
wherein the power supply circuitry includes:
an input portion for obtaining power from a power supply,
an output portion for providing power to an electric component,
a transistor disposed between the input portion and the output portion,
a controller for providing an over-voltage (OV) protection function by turning-on or turning-off a gate of the transistor selectively according to a comparison result between a voltage of a control signal and a threshold configured for the OV protection function,
resistor circuitry disposed in parallel to the output portion, and
detection circuitry connected to the resistor circuitry to obtain at least a part of a voltage applied to the output portion,
wherein the detection circuitry is configured to:
in a case that the voltage applied to the output portion is higher than a clamping voltage, provide the control signal having a voltage higher than the threshold to the controller, and
in a case that the voltage applied to the output portion is lower than or equal to the clamping voltage, provide the control signal having a voltage lower than or equal to the threshold to the controller, and
wherein the clamping voltage is lower than or equal to a tolerance voltage of the electric component.

12. The electronic device of the claim 11, wherein the detection circuitry includes:
comparator circuitry configured to:
obtain a sensing voltage corresponding to a designated ratio of the voltage applied to the output portion through the resistor circuitry,
output a first signal in a case that the sensing voltage is higher than a reference voltage, and
output a second signal in a case that the sensing voltage is lower than or equal to the reference voltage.

13. The electronic device of the claim 12, wherein the detection circuitry includes:
isolation circuitry configured to:
in response to the first signal, generate the control signal having the voltage higher than the threshold,
in response to the second signal, generate the control signal having the voltage lower than or equal to the threshold, and
provide the control signal to an OV port of the controller.

14. The electronic device of the claim 13,
wherein the isolation circuitry includes a load resistor disposed between the input portion and the OV port of the controller, and
wherein the voltage of the control signal is determined based on a magnitude of the load resistor.

15. The electronic device of the claim 14,
wherein the isolation circuitry includes a diode and a bipolar junction transistor (BJT),
wherein forward currents from an anode of the diode to a cathode of the diode cause collector currents to flow from a collector of the BJT to an emitter of the BJT, and
wherein a magnitude of the collector currents with the magnitude of the load resistor provides the control signal having the voltage higher than the threshold.
